# EUROPEAN PATENT APPLICATION

(11) **EP 4 685 265 A1**
(43) Date of publication of application: **28.01.2026**
(21) Application number: 24774055.8
(22) Date of filing: 18.03.2024
(51) Int. Cl.: C23C 16/458, C23C 16/509, H01L 31/18

(54) **WAFER BOAT ASSEMBLY AND SEMICONDUCTOR PROCESS DEVICE**

(30) Priority: 20.03.2023 CN 202310272846
(71) Applicant: Beijing NAURA Microelectronics Equipment Co., Ltd., Beijing 100176 (CN)
(72) Inventor: ZHOU, Zhenxi, Beijing 100176 (CN); YAN, Zhishun, Beijing 100176 (CN); HOU, Pengfei, Beijing 100176 (CN); ZHAO, Fuping, Beijing 100176 (CN); YANG, Laibao, Beijing 100176 (CN)
(74) Representative: LifeTech IP Spies & Behrndt Patentanwälte PartG mbB
(86) International application number: PCT/CN2024/082111
(87) International publication number: WO 2024/193490

(57) **Abstract**

The present disclosure provides a wafer boat assembly and semiconductor process equipment, including multiple wafer boats, which are used to be electrically connected in sequence along an axis of the process chamber in a process chamber. At least one pair of adjacent wafer boats has a front conductive boat pin and a rear conductive boat pin on the bottom of each of the opposite sides, respectively. The top of one of the front conductive boat pin and the rear conductive boat pin has a contact protrusion, and the bottom of the other of the front conductive boat pin and the rear conductive boat pin has a contact groove, which contacts the contact protrusion to electrically connect the adjacent wafer boats. The wafer boat adjacent to the opening on one side of the process chamber is used to electrically connect to a power supply component to receive radio frequency signals provided by the power supply component. The present disclosure electrically connects adjacent wafer boats by overlapping the rear conductive boat pin and the front conductive boat pin, which not only enables the introduction of radio frequency signals from one side and the transmission of radio frequency signals between wafer boats, but also ensures semiconductor process performance and machine production capacity.

## Description

### FIELD OF THE TECHNOLOGY

The present disclosure relates to, but is not limited to, the field of semiconductor process equipment, and in particular, to a wafer boat assembly and a semiconductor process equipment including the wafer boat assembly.

### BACKGROUND

Plasma-enhanced chemical vapor deposition (PECVD) coating is a key process in solar wafer processing, primarily aimed at improving the light conversion efficiency of solar cells. This process utilizes PECVD technology to deposit a deep blue silicon nitride film, also known as an anti-reflective coating, on the surface of the silicon wafer using a graphite boat (wafer boat), radio frequency (RF), and an appropriate amount of reactive gas. Currently, the mainstream coating process in the photovoltaic market utilizes tubular, single-boat PECVD equipment. However, with technological advancements and increasing production capacity requirements, significant cost reductions and efficiency gains are being achieved. The market trend for PECVD equipment is increasingly towards larger tube diameters and higher production capacity, with dual- and multi-boat models being the primary development direction for increasing production capacity.

In practical implementations, whether using a single or dual-boat configuration, the electrodes used to feed the RF signal into the graphite boat must be exposed to high temperatures and the coating process environment for extended periods. Any gaps in contact between the electrodes and the graphite boat can cause the silicon nitride film to adhere to the electrode surface. This can lead to poor contact between the electrodes and the graphite boat, resulting in short circuits, sparks, and other issues. Regular maintenance and cleaning are required to restore the electrodes to normal operation. However, in related-art tubular PECVD equipment, the electrodes typically extend from the rear or mouth of the furnace into the interior. This complex electrode structure leads to cumbersome and time-consuming maintenance procedures, often requiring maintenance while the equipment is shut down. This significantly impacts the maintenance efficiency and machine production capacity of the PECVD equipment.

Therefore, providing semiconductor process with improved maintenance efficiency has become a pressing technical challenge in this field.

### SUMMARY

The present disclosure provides a wafer boat assembly and semiconductor process equipment including the wafer boat assembly. The wafer boat assembly can improve the maintenance efficiency of semiconductor process equipment.

To achieve the above objectives, as one aspect of the present disclosure, a wafer boat assembly is provided, including a plurality of wafer boats, the plurality of wafer boats being electrically connected sequentially along the axial direction of a process chamber. At least one pair of adjacent wafer boats has a front conductive boat pin and a rear conductive boat pin on their bottoms on opposing sides, respectively. One of the front conductive boat pin and the rear conductive boat pin has a contact protrusion on its top, and the other of the front conductive boat pin and the rear conductive boat pin has a contact groove on its bottom. The contact groove contacts the contact protrusion to electrically connect the adjacent wafer boats.

The wafer boat adjacent to the opening on one side of the process chamber is electrically connected to a power supply component to receive radio frequency signals provided by the power supply component.

In some embodiments, the contact protrusion and the contact groove respectively have a first slope and a second slope, the first slope and the second slope are opposite to each other and fit together in a horizontal direction perpendicular to the axial direction of the process chamber, and the opening area of the contact groove gradually increases from top to bottom.

In some embodiments, one of the top of the contact protrusion and the bottom of the contact groove has a positioning protrusion, and the other of the top of the contact protrusion and the bottom of the contact groove has a positioning groove, where the positioning groove mates with the positioning protrusion.

In some embodiments, the bottom of the front conductive boat pin and the bottom of the rear conductive boat pin respectively have a first support surface and a second support surface for contacting a support assembly in the process chamber.

In some embodiments, the support assembly includes two support rods extending along the axis of the process chamber and spaced apart in a horizontal direction perpendicular to the axis of the process chamber. The front conductive boat pins are arranged in pairs on the corresponding wafer boat, and the rear conductive boat pins are arranged in pairs on the corresponding wafer boat. The two first support surfaces of each pair of front conductive boat pins are configured to contact the two supporting rods in a one-to-one correspondence, and the second support surfaces of each pair of rear conductive boat pins are configured to contact the two support rods in a one-to-one correspondence.

In some embodiments, the bottom of the front conductive boat pin further includes a front stopper protruding downwardly relative to the first support surface, and the two front stoppers on the bottom of each pair of the front conductive boat pins are located between the two first support surfaces, so that when the corresponding wafer boat is placed on the support rod, the two front stoppers limit the position of the wafer boat in a direction perpendicular to the axis of the process chamber; and/or,
the bottom of the rear conductive boat pin further includes a rear stopper protruding downwardly relative to the second support surface, and the two rear stoppers on the bottom of each pair of the rear conductive boat pins are located between the two second support surfaces, so that when the corresponding wafer boat is placed on the support rod, the two rear stoppers limit the position of the wafer boat in a direction perpendicular to the axis of the process chamber.

In some embodiments, each wafer boat includes multiple mounting tabs and multiple groups of spacers. The multiple mounting tabs are vertically arranged and extend along the axis of the process chamber and are spaced apart in a direction perpendicular to the axis of the process chamber. The spacers are arranged between adjacent mounting tabs to maintain the spacing between adjacent mounting tabs and to provide electrical connection between adjacent mounting tabs. The projections of the multiple spacers in each group onto the mounting tabs correspond.

The front conductive boat pin further includes at least one front boat pin connector, which is arranged between adjacent mounting tabs and fixedly connected to the corresponding mounting tab. The projection of the front boat pin connector onto the mounting tab corresponds to the projection of the corresponding group of spacers on the wafer boat; and/or,
the rear conductive boat pin further includes at least one rear boat pin connector, which is arranged between adjacent mounting tabs and fixedly connected to the corresponding mounting tab. The projection of the rear boat pin connector onto the mounting tab corresponds to the projection of the corresponding group of spacers on the wafer boat onto the mounting tab.

In some embodiments, each of the wafer boats further includes a plurality of fastening components, the mounting tab is formed with a plurality of first mounting holes penetrating the mounting sheet along a thickness direction, the spacer is formed with a first avoidance hole, the positions of the plurality of groups of spacers correspond one-to-one to the positions of the plurality of first mounting holes, and the plurality of fastening components pass through the first mounting holes of the plurality of mounting tabs and the first avoidance hole on each of the spacers in a one-to-one correspondence to fix the plurality of mounting tabs together;

The front boat pin connector is formed with at least one second mounting hole corresponding to the position of the first mounting hole, so that the front boat pin connector can be fixedly connected to the corresponding mounting tab by the fastening component passing through the second mounting hole and the corresponding plurality of first mounting holes.

The rear boat pin connector is formed with at least one third mounting hole corresponding to the position of the first mounting hole, so that the rear boat pin connector can be fixedly connected to the corresponding mounting tab by the fastening component passing through the third mounting hole and the corresponding plurality of first mounting holes.

As a second aspect of the present disclosure, a semiconductor process equipment is provided, including a power supply component, a process chamber, and the aforementioned wafer boat assembly.

In some embodiments, the process chamber is provided with two support rods extending along the axis of the process chamber and spaced apart in a horizontal direction perpendicular to the axis of the process chamber, for supporting the plurality of wafer boats.

The process chamber is also fixedly provided with at least one pair of locking components, each pair of locking components corresponding to ends of two support rods on the same side, for locking the rotation angle of the support rods.

In some embodiments, the locking component includes a bracket and a pressing plate, the bracket is fixedly arranged in the process chamber; the bracket has a fixing groove, and the end of the support rod is arranged in the fixing groove; the two ends of the pressing plate are respectively fastened to the bracket on both sides of the fixing groove to lock the rotation angle of the support rod through the friction between the pressing plate and the support rod.

In some embodiments, the support rod includes a support rod and at least one first insulating support sleeve and two second insulating support sleeves mounted on the support rod. The first insulating support sleeve is used to support the front conductive boat pins and the rear conductive boat pins of adjacent wafer boats on opposite sides of each other, and the second insulating support sleeve is used to support the boat pins of the wafer boat adjacent to the opening on one side of the process chamber.

In some embodiments, the support rod also includes multiple fixing sleeves mounted on the support rod, with each first insulating support sleeve and each second insulating support sleeve having a fixing sleeve disposed at both ends thereof. The fixing sleeves are used to lock the position of the corresponding first insulating support sleeve or second insulating support sleeve along the extension direction of the support rod.

In some embodiments, the support rod also includes at least one fixing plate, which corresponds to each first insulating support sleeve and is fixedly connected between the two fixing sleeves at both ends of the corresponding first insulating support sleeve.

In the wafer boat assembly and semiconductor process equipment provided by the present disclosure, any adjacent wafer boats have a front conductive boat pin and a rear conductive boat pin on their bottoms on opposite sides, respectively. The top of one of the front and rear conductive boat pins has a contact protrusion, and the bottom of the other of the front and rear conductive boat pins has a contact groove. The contact groove contacts the contact protrusion to electrically connect the adjacent wafer boats. Both the front and rear conductive boat pins serve as electrodes for the wafer boats. Contacting each other through the contact groove and contact protrusion, the adjacent wafer boats can be electrically connected in an overlapping manner, thereby achieving sequential electrical connection of multiple wafer boats. Thus, by electrically connecting only the wafer boat adjacent to an opening on one side of a process chamber (for example, a furnace port of a furnace tube) to the power supply component, the power supply component can provide radio frequency signals to all wafer boats.

Accordingly, compared to the dual-sided RF signal introduction methods in related arts, the embodiments of the present disclosure not only enable single-sided RF signal introduction and RF signal transmission between wafer boats, simplifying the electrode structure of the power supply component for RF signal introduction, but also eliminate the need for the single-sided electrode structure for RF signal introduction to extend to the middle position between the two wafer boats, that is, it does not need to extend too far into the chamber interior. This avoids uncontrollable factors such as large span, large thermal expansion, and displacement error caused by excessive electrode length, thereby ensuring semiconductor process performance. Furthermore, the front and rear conductive boat pins are integrated into the wafer boat and can be removed with the wafer boat for cleaning and maintenance, reducing the difficulty of cleaning and maintaining the wafer boat electrode structure and improving the maintenance efficiency of semiconductor process equipment. Furthermore, because each wafer boat is integrated with the front and/or rear conductive boat pins, all wafer boats have their own electrodes and can be used interchangeably. This allows maintenance on one wafer boat to continue the semiconductor process with the other wafer boat without downtime, thus ensuring machine production capacity.

### BRIEF DESCRIPTION OF THE DRAWINGS

The accompanying drawings are provided to provide a further understanding of the present disclosure and constitute a part of the present disclosure. Together with the following detailed description, they serve to explain the present disclosure but do not limit the present disclosure. In the accompanying drawings:
FIG. 1 is a schematic diagram of the structure of a wafer boat assembly according to an embodiment of the present disclosure;
FIG. 2 is a partially enlarged schematic diagram of area A in Figure 1;
FIG. 3 is a schematic diagram of the structure of the front conductive boat pins in the wafer boat assembly according to an embodiment of the present disclosure;
FIG. 4 is a schematic diagram of the structure of the rear conductive boat pins in the wafer boat assembly according to an embodiment of the present disclosure;
FIG. 5 is a schematic diagram of the structure of the rear conductive boat pins in the wafer boat assembly according to an embodiment of the present disclosure from another perspective;
FIG. 6 is a schematic diagram of the principle of overlapping the front and rear conductive boat pins in the wafer boat assembly according to an embodiment of the present disclosure;
FIG. 7 is a schematic diagram of the structure of a support rod in a semiconductor process equipment according to an embodiment of the present disclosure;
FIG. 8 is a schematic diagram of the mounting relationship between the support rods and the process chamber in the semiconductor process equipment according to an embodiment of the present disclosure;
FIG. 9 is a schematic diagram of the structure of a locking assembly in the semiconductor process equipment according to an embodiment of the present disclosure.

### DETAILED DESCRIPTION

The following describes in detail specific embodiments of the present disclosure with reference to the accompanying drawings. It should be understood that the specific embodiments described herein are intended only to illustrate and explain the present disclosure and are not intended to limit the present disclosure.

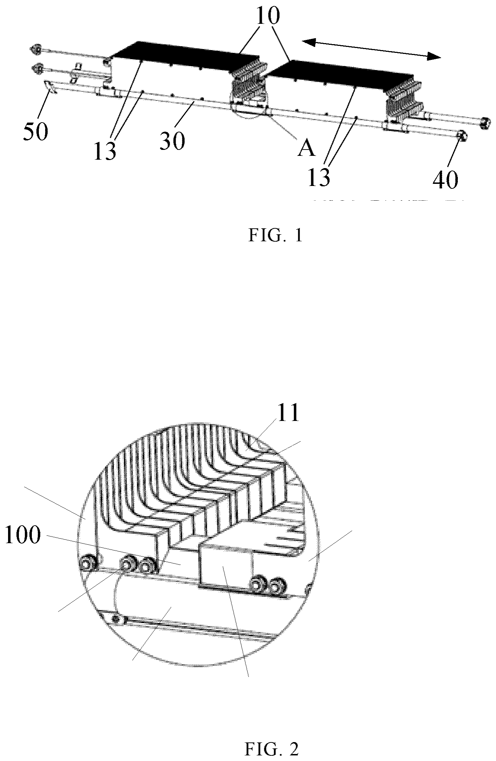

To address the aforementioned technical issues, as one aspect of the present disclosure, a wafer boat assembly is provided. As shown in FIGs. 1 and 2, the wafer boat assembly includes multiple wafer boats 10. The multiple wafer boats 10 are electrically connected sequentially along the axis of the process chamber 20 (for example, the direction of the double-headed arrow in FIG. 1) within a process chamber 20. Specifically, during the process of moving the multiple wafer boats 10 into or out of the process chamber 20, the multiple wafer boats 10 sequentially enter and exit the process chamber 20 along the axis of the process chamber 20. For ease of description, the "front side" and "rear side" of the wafer boat 10 in the process chamber 20 refer, respectively, to the front side and rear side of the wafer boat 10 when entering and exiting the process chamber 20.

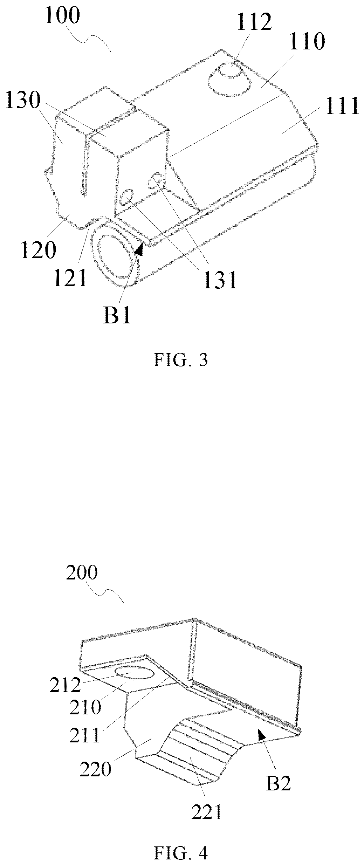

Any two adjacent wafer boats form a pair, and at least one of the adjacent wafer boats in the pair has a front conductive boat pin 100 and a rear conductive boat pin 200 on the bottom of opposite sides. That is, when the wafer boats 10 are moved into the process chamber 20, one of the wafer boats 10 is located at the front side, while the other wafer boat 10 is located at the rear side. The front bottom of the wafer boat 10 located at the rear side (referred to as the boat exit side) has the front conductive boat pin 100, while the rear bottom of the wafer boat 10 located at the front side (referred to as the boat entrance side) has the rear conductive boat pin 200. One of the front conductive boat pin 100 and the rear conductive boat pin 200 has a contact protrusion 110 on its top, and the other of the front conductive boat pin 100 and the rear conductive boat pin 200 has a contact groove 210 on its bottom. Furthermore, the contact groove 210 contacts the contact protrusion 110 to electrically connect the adjacent wafer boats 10. In one example, as shown in FIG. 3, the top of the front conductive boat pin 100 has a contact protrusion 110, and as shown in FIG. 4, the bottom of the rear conductive boat pin 200 has a contact groove 210.

Among the multiple wafer boats 10, the wafer boat 10 adjacent to an opening on one side of the process chamber 20 is electrically connected to a power supply component to receive radio frequency signals provided by the power supply component. This allows radio frequency power to be applied to the wafer boat 10 for performing semiconductor processes (for example, thin film deposition processes such as PECVD) on the wafers carried by the wafer boat 10.

In some embodiments, as shown in FIG. 1, taking two wafer boats 10 as an example, the rear wafer boat 10 is adjacent to an opening on the left side (for example, the boat entrance side) of the process chamber 20 (for example, the furnace opening corresponding to the front furnace door of the furnace tube), while the front wafer boat 10 is adjacent to an opening on the right side (for example, the boat exit side) of the process chamber 20 (for example, the furnace opening corresponding to the rear furnace door of the furnace tube). In this case, the power supply component, for example, includes an RF power supply and an electrode structure for introducing RF signals. The electrode structure, for example, includes two electrode rods (the wafer boat 10 on the left in FIG. 1 has two electrode rods connected to its left side). The two electrode rods are mounted on the left side of the furnace door of the process chamber 20 and are electrically connected to the positive and negative poles of the external RF power supply, respectively. The ends of the two electrode rods, distal from the RF power supply, extend into the process chamber 20 and are electrically connected to the wafer boat 10 on the left in FIG. 1.

In some embodiments, each wafer boat 10 includes a plurality of mounting tabs 11, each of which is vertically arranged and extends along the axis of the process chamber and is spaced apart in a direction perpendicular to the axis of the process chamber. The two electrode rods are electrically connected to the wafer boat 10, for example, such that the polarity of some mounting tabs 11 in the wafer boat 10 is opposite to that of other mounting tabs 11. It should be noted that the specific methods for electrically connecting the two electrode rods to the wafer boat 10, as well as the specific methods for electrically connecting the wafer boats 10 to each other, can be referenced in related art and are not specifically limited here.

In the wafer boat assembly provided by the embodiments of the present disclosure, any adjacent wafer boats 10 have a front conductive boat pin 100 and a rear conductive boat pin 200 on their bottoms on opposite sides, respectively. A contact protrusion 110 is formed on the top of one of the front conductive boat pin 100 and the rear conductive boat pin 200, while a contact groove 210 is formed on the bottom of the other of the front conductive boat pin 100 and the rear conductive boat pin 200. The contact groove 210 contacts the contact protrusion 110 to electrically connect the adjacent wafer boats 10. Both the front conductive boat pin 100 and the rear conductive boat pin 200 serve as electrodes for the wafer boats 10. Contacting each other through the contact groove 210 and the contact protrusion 110, the adjacent wafer boats 10 can be electrically connected in an overlapping manner, thereby achieving sequential electrical connection of multiple wafer boats 10. In this way, only the wafer boat 10 adjacent to an opening on one side of the process chamber 20 (for example, the furnace port of a furnace tube) needs to be electrically connected to the power supply component, and the power supply component can provide RF signals to all wafer boats.

Accordingly, compared to the dual-sided RF signal introduction method in the related art, the embodiments of the present disclosure not only enable single-sided RF signal introduction and RF signal transmission between wafer boats 10, simplifying the electrode structure for introducing RF signals in the power supply component, but also eliminates the need for the single-sided electrode structure for introducing RF signals to extend into the middle between the two wafer boats, for example, it does not need to extend too far into the chamber. This avoids uncontrollable factors such as large span, large thermal expansion, and displacement error caused by excessive electrode length, thereby ensuring semiconductor process performance. Furthermore, the front conductive boat pins 100 and the rear conductive boat pins 200 are both integrated with the wafer boat and can be removed with the wafer boat for cleaning and maintenance, reducing the operational difficulty of cleaning and maintaining the wafer boat electrode structure and improving the maintenance efficiency of semiconductor process equipment. Furthermore, since each wafer boat 10 is integrated with the front conductive boat pins 100 and/or the rear conductive boat pins 200, all wafer boats 10 have their own electrodes and can be used interchangeably. This allows maintenance on one wafer boat to be replaced with another wafer boat to continue the semiconductor process without downtime, thus ensuring machine production capacity.

The rear conductive boat pins 200 and the front conductive boat pins 100 serve as electrodes for the wafer boats 10. Adjacent wafer boats 10 are electrically connected by overlapping the rear conductive boat pins 200 and the front conductive boat pins 100. This arrangement requires only one electrode (for example, the electrode rod in FIG. 1) to be positioned within the process chamber 20 corresponding to one of the multiple wafer boats 10 located on the boat entrance side (for example, the left side in FIG. 1). Connecting this boat 10 on the boat entrance side to the power supply component provides RF signals to all wafer boats 10.

In the wafer boat assembly provided by the disclosed embodiments, the wafer boats 10 can be electrically connected via the front and rear conductive boat pins. This eliminates the need for electrodes at the opening of the process chamber 20 (for example, the furnace port) to power the wafer boat 10 on the boat exit side (for example, the right side in FIG. 1), or for additional electrodes. This avoids uncontrollable factors such as the large span of the electrode from the opening of the process chamber 20 to the interior of the process chamber 20, resulting in large thermal expansion and displacement errors, thereby ensuring optimal semiconductor processing performance. Furthermore, the front conductive boat pins 100 and rear conductive boat pins 200, which serve as electrodes, are integrated into the wafer boat 10 and can be removed with the wafer boat 10 for separate cleaning and maintenance. This reduces the difficulty of cleaning and maintaining the electrode structure, improving the maintenance efficiency of semiconductor process equipment. Furthermore, maintenance on the wafer boat 10 does not require downtime; the semiconductor process can continue using the process chamber 20 and the replacement wafer boat 10, further improving maintenance efficiency and ensuring machine throughput.

It should be noted that if there are two wafer boats 10, one of the two wafer boats 10 is equipped with the front conductive boat pins 100, and the other is equipped with the rear conductive boat pins 200, to achieve electrical connection between the two wafer boats 10. For example, if there are three or more wafer boats 10, the center wafer boat 10 is equipped with the front conductive boat pins 100 and the rear conductive boat pins 200, while one of the two wafer boats 10 is equipped with the front conductive boat pins 100 and the other with the rear conductive boat pins 200, to achieve sequential electrical connection between the three wafer boats.

To further ensure the relative positional accuracy of adjacent wafer boats and the stability of the wafer boat 10, in some embodiments, as shown in FIGs. 3 and 4, the contact protrusion 110 and the contact groove 210 have a first slope 111 and a second slope 211, respectively. The first slope 111 and the second slope 211 oppose each other and align with each other along a horizontal direction perpendicular to the axis of the process chamber 20. The opening area of the contact groove 210 gradually increases from top to bottom, and accordingly, the horizontal cross-sectional area of the contact protrusion 110 gradually increases from top to bottom. For example, in the case where the front conductive boat pin 100 has the contact protrusion 110 at the top and the rear conductive boat pin 200 has the contact groove 210 at the bottom, the second slope 211 is the inner side surface of the contact groove 210, which is inclined relative to the vertical plane. Corresponding to the second slope 211, the first slope 111 is the outer side surface of the contact protrusion 110, which faces the inner side surface and has the same inclination direction. As a result, when multiple wafer boats 10 are dropped into the process chamber 20, each contact groove 210 engages with the corresponding contact protrusion 110. During this process, the first and second slopes 111 and 211 cooperate to provide guidance, ensuring the relative positioning accuracy of adjacent wafer boats.

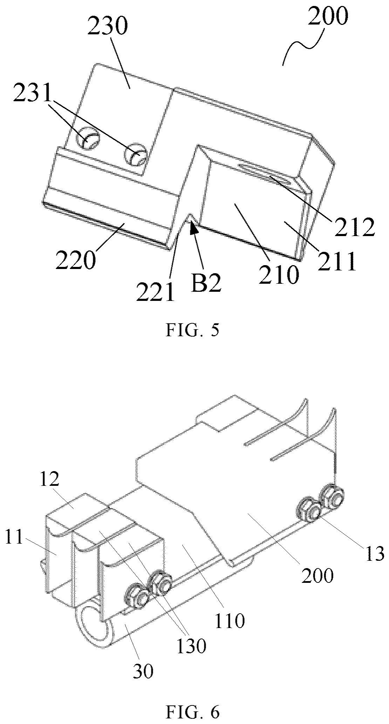

To further ensure the relative positioning accuracy of adjacent wafer boats and the stability of the wafer boats 10, in some embodiments, one of the top of the contact protrusion 110 or the bottom of the contact groove 210 has a positioning protrusion 112, and the other of the top of the contact protrusion 110 and the bottom of the contact groove 210 has a positioning groove 212 that mates with the positioning protrusion 112. In one example, as shown in FIG. 3, the top of the contact protrusion 110 has a positioning protrusion 112, and as shown in FIG. 4 and FIG. 5, the bottom of the contact groove 210 (for example, the downward-facing inner surface of the groove in FIG. 4) has a positioning groove 212. The shape and position of the positioning groove 212 correspond to the positioning protrusion 112, ensuring a secure and aligned position. The positioning protrusions 112 are used to be received in the corresponding positioning grooves 212 of the wafer boat 10 located on the boat entrance side when the corresponding wafer boat 10 enters the process chamber 20. The positioning grooves 212 and the positioning protrusions 112 are, for example, both truncated cone-shaped, with the outer diameter gradually decreasing from bottom to top. That is, the side surface of the positioning protrusion 112 is formed into a conical surface. Even if the initial relative position between the leading conductive boat pin 100 and the trailing conductive boat pin 200 is not aligned, when the positioning protrusion 112 is gradually inserted into the positioning grooves 212, the positioning protrusion 112 and the positioning grooves 212 can be automatically aligned due to the matching relationship between the conical surfaces, so that the relative position between the leading conductive boat pin 100 and the trailing conductive boat pin 200 is also aligned accordingly, achieving automatic correction of the positions of the leading conductive boat pin 100 and the trailing conductive boat pin 200, further ensuring the stability of the position of the wafer boat 10.

In some embodiments, the horizontal cross-sectional area of the positioning protrusion 112 gradually decreases from bottom to top, and the shape of the positioning groove 212 corresponds to this. This allows the positioning protrusion 112 to more easily fit into the positioning groove 212. As the positioning protrusion 112 gradually enters into the positioning groove 212, the positioning protrusion 112 and the positioning groove 212 are automatically aligned, thereby automatically correcting the relative position between the front conductive boat pin 100 and the rear conductive boat pin 200, further improving the relative positioning accuracy of adjacent wafer boats. Of course, in actual implementations, the positioning groove 212 and the positioning protrusion 112 can also be formed using other rotating bodies with a gradually decreasing horizontal cross-sectional area from bottom to top, and this is not particularly limited in the presently disclosed embodiments.

In some embodiments, as shown in FIGs. 3 to 5, the bottoms of the front conductive boat pin 100 and the rear conductive boat pin 200 respectively have a first support surface B1 and a second support surface B2 for contacting the support assembly in the process chamber 20. The first support surface B1 and the second support surface B2 are, for example, flat surfaces. These flat surfaces contact the cylindrical surfaces of the support rods 30, providing stable support for the wafer boat 10. In practical implementations, the first support surface B1 and the second support surface B2 can also be curved concave surfaces, which mate with the cylindrical surfaces of the support rods 30.

In some embodiments, as shown in FIGs. 1, 2, 7, and 8, the support assembly includes two support rods 30 extending along the axis of the process chamber 20 and spaced apart in a horizontal direction perpendicular to the axis of the process chamber 20. The front conductive boat pins 100 are arranged in pairs on corresponding wafer boats 10, and the rear conductive boat pins 200 are arranged in pairs on corresponding wafer boats 10. The two first support surfaces B1 of each pair of leading conductive boat pins 100 are configured to contact the two support rods 30 in a one-to-one manner, and the two second support surfaces B2 of each pair of rear conductive boat pins 200 are configured to contact the two support rods 30 in a one-to-one manner.

It should be noted that each pair of front conductive boat pins 100 and each pair of rear conductive boat pins 200 also correspond to each other in a pair-by-two relationship. That is, for any adjacent wafer boats 10, if a pair of front conductive boat pins 100 is provided at the bottom of the front side (called the boat exit side) of one of the wafer boats 10 (for example, the wafer boat 10 on the left in FIG. 1), then a pair of rear conductive boat pins 200 must also be provided at the bottom of the rear side (called the boat entry side) of the other adjacent wafer boat 10 (for example, the wafer boat 10 on the right in FIG. 1), so as to realize electrical connection between the adjacent wafer boats 10 through the overlap between the pair of front conductive boat pins 100 and the pair of rear conductive boat pins 200. Similarly, for any adjacent wafer boats 10, if a pair of rear conductive boat pins 200 are provided at the bottom of the front side (called the boat exit side) of one of the wafer boats 10 (for example, the wafer boat 10 on the left in FIG. 1), then a pair of front conductive boat pins 100 are also required to be provided at the bottom of the rear side (called the boat entry side) of the other adjacent wafer boat 10 (for example, the wafer boat 10 on the right in FIG. 1) so as to achieve electrical connection between the two adjacent wafer boats 10 through the overlap between the front and rear conductive boat pins.

To further enhance the stability of the wafer boat 10's position, in some embodiments, as shown in FIG. 3, the bottom of the front conductive boat pins 100 further includes a front stopper 120 protruding downwardly from the first support surface B1. The two front stoppers 120 on the bottom of each pair of front conductive boat pins 100 are located between the two first support surfaces B1 of the pair. When the corresponding wafer boat 10 is placed on the two support rods 30, they are positioned between the two support rods 30. The two front stoppers 120 limit the position of the wafer boat 10 relative to the two support rods 30, perpendicular to the axis of the process chamber 20. As shown in FIG. 3, in some examples, the front stopper 120 is located, for example, behind the contact protrusion 110, for example, the contact protrusion 110 is closer to the contact groove 210 than the front stopper 120.

To further enhance the stability of the wafer boat 10's position, in some embodiments, as shown in FIGs. 4 and 5, the bottom of the rear conductive boat pins 200 further include rear stoppers 220 that protrude downwardly from the second support surface B2. The two rear stoppers 220 on the bottom of each pair of rear conductive boat pins 200 are located between the two second support surfaces B2 of the pair. When the corresponding wafer boat 10 is placed on the two support rods 30, they are positioned between the two support rods 30. The rear stoppers 220 limit the position of the wafer boat 10 relative to the two support rods 30 in a direction perpendicular to the axis of the process chamber 20. As shown in FIGs. 4 and 5, the rear stoppers 220 are, for example, located forward of the contact groove 210. That is, the contact groove 210 is closer to the contact protrusion 110 than the rear stoppers 220, meaning that the contact groove 210 is located on the boat-entering side of the corresponding rear stopper 220.

In the embodiments of the present disclosure, the bottoms of the front conductive boat pin 100 and the rear conductive boat pin 200 are both provided with limit blocks (for example, the front stopper 120 and the rear stopper 220), and the stoppers on both sides are both located between the support surfaces on both sides (for example, the first support surface B1 on both sides or the second support surface B2 on both sides), that is, the stoppers on both sides (for example, the front stopper 120 and the rear stopper 220) can be correspondingly inserted between the two support rods 30, so that when the wafer boat 10 is placed on the support rods 30, the support rods 30 on both sides can respectively limit the stoppers of the corresponding conductive boat pins (for example, the front conductive boat pin 100 and the rear conductive boat pin 200), thereby preventing the wafer boat 10 from sliding to both sides, thereby improving the stability of the position of the wafer boat 10 and ensuring the safety of the semiconductor process.

In some embodiments, as shown in FIG. 3, the outer side of the front stopper 120 (for example, the side facing away from the opposite front conductive boat pin 100) has a front guiding slope 121 that slopes inward (for example, toward the side between the pair of front conductive boat pins 100). This front guiding slope 121 of the front stopper 120 transitions to the first support surface B1 of the front stopper 120 in an arc-shaped transition. In some examples, the inclination direction of the first slope 111 is opposite to that of the front guiding slope 121 of the corresponding front conductive boat pin 100, for example, the first slope 111 slopes outward. Furthermore, in a horizontal direction perpendicular to the axis of the process chamber 20, the first slope 111 is located on the side of the corresponding front conductive boat pin 100 that is away from the opposite front conductive boat pin 100. Specifically, the contact protrusion 110 has a first slope 111 on the side facing away from the opposite front stopper 120, tilted toward the opposite front stopper 120 (for example, tilted toward the inner side between the two front conductive boat pins 100).

In some embodiments, as shown in FIGs. 4 and 5, the outer side of the rear stopper 220 (for example, the side facing away from the opposite rear conductive boat pin 200) has an inwardly rear guiding slope 221. This rear guiding slope 221 of the rear stopper 220 transitions to the second support surface B2 of the rear stopper 220 in a circular arc. In some examples, the inclination direction of the second slope 211 is opposite to that of the rear guiding slope 221, that is, the second slope 211 is outwardly inclined. Furthermore, in a horizontal direction perpendicular to the axis of the process chamber 20, the second slope 211 is located on the side of the rear conductive boat pin 200 facing away from the opposite rear conductive boat pin 200. Specifically, as shown in FIGs. 4 and 5, the sidewall of the contact groove 210 facing away from the opposite rear stopper 220 is formed as the second slope 211, which is configured to mate with the first slope 111.

In the disclosed embodiments, the outer side of the front stopper 120 has an inwardly inclined front guiding slope 121, and the outer side of the rear stopper 220 has an inwardly inclined rear guiding slope 221. Circular arc transitions are formed between the front guiding slope 121 and the first support surface B1, and between the rear guiding slope 221 and the second support surface B2. Therefore, when the wafer boat 10 is placed on the support rod 30, the guide bevels of the stopper (for example, the front guiding slope 121 and the rear guiding slope 221) cooperate with the support rod 30 to provide guidance, providing real-time correction of the horizontal position of the wafer boat 10 and further improving the positional stability of the wafer boat 10. Furthermore, the circular arc transition between the guide bevels and the support surface provides a buffering effect when the support rod 30 is about to contact the support surface, reducing the impact of vibration caused by the collision between the support rod 30 and the support surface on the wafer boat, further ensuring the effectiveness of individual semiconductor processes.

In some embodiments, as shown in FIGs. 1 and 2, each wafer boat 10 includes multiple mounting tabs 11 and multiple groups of spacers 12. The multiple mounting tabs 11 are vertically arranged and extend along the axis of the process chamber 20, and are spaced apart in a direction perpendicular to the axis of the process chamber 20. The spacers 12 are arranged between adjacent mounting tabs 11 to maintain the spacing between adjacent mounting tabs 11 and to electrically connect adjacent mounting tabs 11. The gaps between the mounting tabs 11 are used to support wafers, and the multiple spacers 12 in each group have corresponding projection positions on the mounting tabs 11. It should be noted that the adjacent mounting tabs 11 here refer to a portion of all the mounting tabs 11 that are adjacent on one side, and the spacers 12 on this side can maintain the spacing between adjacent mounting tabs 11 in this portion and electrically connect them. It is easy to understand that another portion of the mounting tabs 11 are adjacent on the other side, and the spacers 12 on the other side maintain the spacing between them and electrically connect them. For example, as shown in FIG. 2, a portion of the mounting tabs 11 on the left side of the wafer boat 10 are adjacent to each other on its right side. The spacers 12 on the right side of the wafer boat 10 maintain spacing between adjacent mounting tabs 11 within this portion and electrically connect them. In practice, multiple spacers 12 are electrically connected to a portion of the mounting tabs 11, ensuring that the polarity of one portion of the mounting tabs 11 in the wafer boat 10 is opposite to that of another portion when the power supply component is turned on. This is well known technology and will not be described in detail here.

In some embodiments, as shown in FIGs. 1 to 3, the front conductive boat pin 100 further includes at least one front boat pin connector 130. For example, FIG. 3 shows two front boat pin connectors 130. These front boat pin connectors 130 are positioned between adjacent mounting tabs 11 and fixedly connected to the corresponding mounting tabs 11. The projection of the front boat pin connectors 130 on the mounting tab 11 corresponds to the projection of the corresponding set of spacers 12 on the wafer boat 10 on the mounting tab 11. That is, the positions of a group of spacers 12 correspond to the front boat pin connectors 130, and the front boat pin connectors 130 on the front boat pin connectors 130 replace at least one spacer 12 at a corresponding position in the group of spacers 12 on a one-to-one basis, that is, the front boat pin connectors 130 on the front boat pin connectors 130 replace the spacer 12 at a corresponding position in the group of spacers 12 at the bottom of the rear end of the front boat. The front boat pin connectors 130 are provided on the front conductive boat pin 100, and their function is the same as that of the above-mentioned spacers 12, namely, electrically connecting the two mounting tabs 11. In other words, the front boat pin connectors 130 on the front conductive boat pin 100 can be used as spacers 12. For example, the front conductive boat pin 100 located at the front bottom of the wafer boat 10 at the rear side, at least one front boat pin connectors 130 thereon can replace at least one spacer 12 at the front bottom of the wafer boat 10 on a one-to-one basis and be provided between the corresponding two mounting tabs 11 at the front bottom of the wafer boat 10.

In some embodiments, as shown in FIGs. 5 and 6, the rear conductive boat pin 200 further includes at least one rear boat pin connector 230. The rear boat pin connector 230 is disposed between adjacent mounting tabs 11 and fixedly connected to the corresponding mounting piece 11. The projection position of the rear boat pin connector 230 on the mounting tab 11 corresponds to the projection position of a group of spacers 12 on the wafer boat 10 on the mounting tab 11. That is, the positions of the group of spacers 12 correspond to the rear conductive boat pin 200, and the rear boat pin connector 230 on the rear conductive boat pin 200 replaces at least one spacer 12 at a corresponding position in the group of spacers 12 on a one-to-one basis. That is, the rear boat pin connector 230 on the rear conductive boat pin 200 replaces the spacer 12 at a corresponding position in the group of spacers 12 at the bottom of the front end of the rear boat. The rear boat pin connector 230 is provided on the rear conductive boat pin 200. Its function is similar to the aforementioned spacer 12, namely, to electrically connect the two mounting tabs 11. In other words, the rear boat pin connector 230 on the rear conductive boat pin 200 can also function as a spacer 12. For example, at least one rear boat pin connector 230 on the rear conductive boat pin 200 located on the rear bottom of the front wafer boat 10 can replace at least one spacer 12 on the rear bottom of the wafer boat 10 and be positioned between corresponding two mounting tabs 11 on the rear bottom of the wafer boat 10.

In some embodiments, as shown in FIGs. 1, 2, and 6, at least one front boat pin connector 130 on the front conductive boat pin 100 is fixedly connected to the corresponding mounting tab 11. Furthermore, at least one rear boat pin connector 230 on the rear conductive boat pin 200 is fixedly connected to the corresponding mounting tab 11. Furthermore, each set of spacers 12 is fixedly connected to the corresponding mounting tab 11. There are many ways to achieve the above-mentioned fixed connection. For example, the wafer boat 10 also includes multiple fastening components 13. The mounting tab 11 is formed with multiple first mounting holes that pass through the mounting tab 11 along the thickness direction of the mounting tab 11 (that is, along the direction perpendicular to the axis of the process chamber 20). A first avoidance hole is formed on the spacer 12. The positions of the multiple groups of spacers 12 correspond one-to-one to the positions of the multiple first mounting holes. The multiple fastening components 13 pass through the first mounting holes of the multiple mounting tabs 11 and the first avoidance holes on each spacer 12 one-to-one to fix the multiple mounting tabs 11 to the spacers 12.

In some embodiments, as shown in FIGs. 1, 2, and 6, the fastening component 13 may be a bolt.

In some embodiments, as shown in FIGs. 3 and 6, the front boat pin connector 130 is formed with at least one second mounting hole 131 corresponding to the position of the first mounting hole. The fastening assembly 13, which passes through the second mounting hole 131 and the corresponding plurality of first mounting holes, securely connects the front boat pin connector 130 to the corresponding mounting tab 11.

In some embodiments, as shown in FIGs. 5 and 6, the rear boat pin connector 230 is formed with at least one third mounting hole 231 corresponding to the position of the first mounting hole. The fastening assembly 13, which passes through the third mounting hole 231 and the corresponding plurality of first mounting holes, securely connects the rear boat pin connector 230 to the corresponding mounting tab 11.

In some embodiments, as shown in FIG. 1, the wafer boat assembly includes two wafer boats 10.

In some embodiments, as shown in FIG. 3, the front conductive boat pin 100 includes two front boat pin connectors 130. In some embodiments, the rear conductive boat pin 200 includes two rear boat pin connectors 230.

In some embodiments, as shown in FIG. 3, two second mounting holes 131 are formed in the front boat pin connector 130. In some embodiments, as shown in FIG. 5, two third mounting holes 231 are formed in the rear boat pin connector 230.

As a second aspect of the present disclosure, a semiconductor process equipment is provided, including a power supply component, a process chamber 20, and a wafer boat assembly according to an embodiment of the present disclosure.

In the semiconductor process equipment provided by the present disclosure, any adjacent wafer boats 10 have a front conductive boat pin 100 and a rear conductive boat pin 200 on their bottoms on opposite sides, respectively. One of the front conductive boat pin 100 and the rear conductive boat pin 200 has a contact protrusion 110 on its top, and the other of the front conductive boat pin 100 and the rear conductive boat pin 200 has a contact groove 210 on its bottom. The contact groove 210 contacts the contact protrusion 110 to electrically connect the adjacent wafer boats 10. Both the front conductive boat pin 100 and the rear conductive boat pin 200 serve as electrodes for the wafer boats 10. Contacting each other through the contact groove 210 and the contact protrusion 110, the adjacent wafer boats 10 can be electrically connected in an overlapping manner, thereby achieving sequential electrical connection of multiple wafer boats 10. In this way, only the wafer boat 10 adjacent to an opening on one side of the process chamber 20 (for example, the furnace port of a furnace tube) needs to be electrically connected to the power supply component, and the power supply component can provide RF signals to all wafer boats.

Accordingly, compared to the dual-sided RF signal introduction method in the related art, the embodiments of the present disclosure not only enable single-sided RF signal introduction and RF signal transmission between wafer boats 10, simplifying the electrode structure used for RF signal introduction in the power supply component, but also eliminates the need for the single-sided RF signal introduction electrode structure to extend into the middle between the two wafer boats, meaning it does not need to extend too far into the chamber. This avoids uncontrollable factors such as large span, thermal expansion, and displacement errors caused by excessive electrode length, thereby ensuring semiconductor process performance. Furthermore, the front conductive boat pins 100 and the rear conductive boat pins 200 are integrated with the wafer boat and can be removed with the wafer boat for cleaning and maintenance, reducing the difficulty of cleaning and maintaining the wafer boat electrode structure and improving the maintenance efficiency of semiconductor process equipment. Furthermore, since each wafer boat 10 is integrated with the front conductive boat pins 100 and/or the rear conductive boat pins 200, all wafer boats 10 have their own electrodes and can be used interchangeably. This allows maintenance on one wafer boat to continue semiconductor processing on another without downtime, thus ensuring machine productivity.

In some embodiments, as shown in FIG. 1 and FIG. 2, the process chamber 20 is provided with two support members extending along the axial direction of the process chamber 20 and spaced apart in a horizontal direction perpendicular to the axial direction of the process chamber 20 for supporting multiple wafer boats 10.

To ensure the stability of the wafer boat 10, in some embodiments, as shown in FIGs 1, 7, and 8, at least one pair of locking components 40 are fixedly installed in the process chamber 20. Each pair of locking components 40 corresponds to the ends of two support rods 30 on the same side, and is used to lock the rotation angle of the support rods 30.

In the disclosed embodiments, at least one pair of locking components 40 are also fixedly installed in the process chamber 20. The locking components 40 can lock the rotation angle of the support rods 30, thereby preventing the rotation of the support rods 30 from affecting the stability of the wafer boat 10.

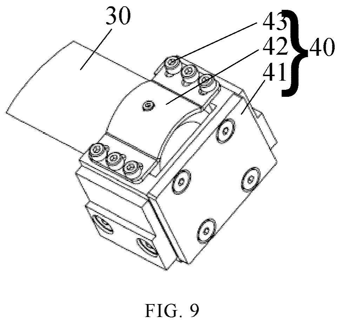

In some embodiments, as shown in FIG. 9, the locking component 40 includes a bracket 41 and a pressing plate 42. The bracket 41 is fixedly installed in the process chamber 20. The bracket 41 has a fixing groove in which the ends of the support rods 30 are mounted. The ends of the pressing plate 42 are fastened to the bracket 41 on either side of the fixing groove. The friction between the pressing plate 42 and the support rods 30 locks the rotation angle of the support rods 30.

In the disclosed embodiment, the ends of the pressing plate 42 are securely connected to the bracket 41 at either side of the fixing slot. The elasticity of the pressing plate 42 applies preload pressure to the support rod 30 in the fixing slot of the bracket 41. Furthermore, the static friction between the pressing plate 42 and the support rod 30 locks the rotation angle of the support rod 30.

In some embodiments, as shown in FIG. 9, the pressing plate 42 has a circular concave surface corresponding to the support rod 30.

In some embodiments, the pressing plate 42 is made of silicon carbide.

In some embodiments, as shown in FIG. 9, the locking component 40 further includes multiple locking screws 43. Multiple locking holes are formed at both ends of the pressing plate 42, extending through the thickness of the pressing plate 42. The bracket 41 also includes multiple threaded locking holes. The multiple locking screws 43 pass through the corresponding locking holes and threaded locking holes to securely connect the pressing plate 42 to the bracket 41.

In some embodiments, as shown in FIGs. 1, 7, and 8, the support rod 30 further includes a rear bracket 50. The boat-entering end of the support rod 30 is connected to the process chamber 20 via the rear bracket 50.

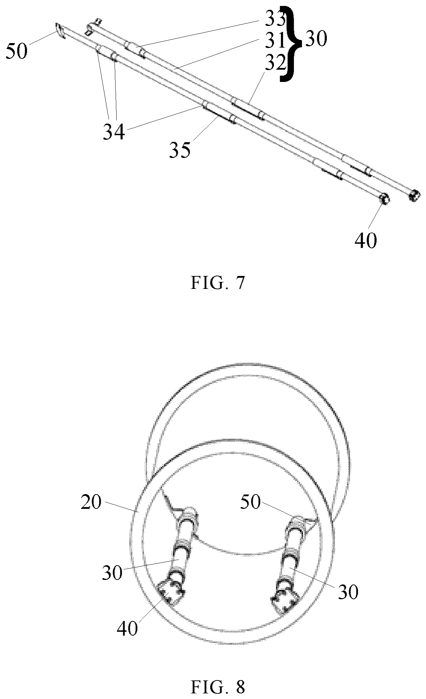

In some embodiments, as shown in FIGs. 7 and 8, each support rod 30 includes a support stick 31 and at least one first insulating support sleeve 32 and two second insulating support sleeves 33 mounted on the support stick 31. The first insulating support sleeve 32 supports the front conductive boat pin 100 and rear conductive boat pin 200 of two adjacent wafer boats 10 on opposite sides of each other. The second insulating support sleeve 33 supports the pins of the wafer boat 10 adjacent to an opening on one side of the process chamber 20. Specifically, a pair of pins is provided on the front and rear bottoms of each wafer boat 10. One of the multiple wafer boats 10 is adjacent to one opening of the process chamber 20 (for example, the furnace opening corresponding to the front door of the furnace tube), while another wafer boat 10 is adjacent to the other opening of the process chamber 20 (for example, the furnace opening corresponding to the rear door of the furnace tube). In this case, the second insulating support sleeve 33 supports the pins of the bottom of the wafer boats 10 adjacent to each opening.

In some embodiments, the support stick 31 is made of silicon carbide (SiC). Silicon carbide has excellent properties such as high hardness, high strength, high temperature resistance, and corrosion resistance, effectively ensuring the structural strength of the support stick 31 in semiconductor processing environments.

In some embodiments, the first insulating support sleeve 32 and the second insulating support sleeve 33 are both made of ceramic.

In some embodiments, as shown in FIG. 7, the support rod 30 also includes multiple fixing sleeves 34. The fixing sleeves 34 are mounted on the support stick 31. Each first insulating support sleeve 32 and each second insulating support sleeve 33 has a fixing sleeve 34 at each end. The fixing sleeves 34 are used to lock the corresponding first insulating support sleeve 32 or second insulating support sleeve 33 in position along the extension direction of the support stick 31, preventing the first insulating support sleeve 32 or second insulating support sleeve 33 from sliding along the support stick 31 and misaligning with the boat pins. This ensures the stability of the wafer boat 10 while further preventing direct contact between the boat pins and the support stick 31 and causing short circuits, thereby improving the safety of the semiconductor process.

In some embodiments, as shown in FIG. 7, the support rod 30 further includes at least one fixing plate 35. The fixing plates 35 correspond one-to-one with the first insulating support sleeves 32 and are fixedly connected between the two fixing sleeves 34 at either end of the corresponding first insulating support sleeve 32. This effectively prevents the fixing sleeve 34 on one side from detaching from the first insulating support sleeve 32, ensuring the stability of the two fixing sleeves 34 on either side of the first insulating support sleeve 32. This further ensures the stability of the position of the first insulating support sleeve 32 and, consequently, the position of the wafer boat 10.

It should be understood that the above embodiments are merely exemplary embodiments used to illustrate the principles of the present disclosure and are not intended to be limiting. Persons skilled in the art will readily appreciate that various modifications and improvements can be made without departing from the spirit and substance of the present disclosure, and such modifications and improvements are considered within the scope of protection of the present disclosure.

## Claims

1. A wafer boat assembly, comprising a plurality of wafer boats, the plurality of wafer boats being electrically connected sequentially along an axial direction of a process chamber, the assembly is **characterized in that** at least one pair of adjacent wafer boats has a front conductive boat pin and a rear conductive boat pin on their bottoms on opposing sides, respectively, a top of one of the front conductive boat pin and the rear conductive boat pin has a contact protrusion,
and a bottom of the other of the front conductive boat pin and the rear conductive boat pin has a contact groove, the contact groove contacting the contact protrusion to electrically connect the adjacent wafer boats;
the wafer boat adjacent to an opening on one side of the process chamber is electrically connected to a power supply component to receive radio frequency signals provided by the power supply component.

2. The wafer boat assembly according to claim 1, wherein the contact protrusion and the contact groove each have a first slope and a second slope, the first slope and the second slope facing each other and abutting each other along a horizontal direction perpendicular to the axial direction of the process chamber, and an opening area of the contact groove gradually increases from top to bottom.

3. The wafer boat assembly according to claim 1 or 2, wherein one of the top of the contact₊ protrusion and the bottom of the contact groove has a positioning protrusion, and the other of the top of the contact protrusion and the bottom of the contact groove has a positioning groove, and the positioning groove mates with the positioning protrusion.

4. The wafer boat assembly according to claim 1 or 2, wherein the bottom of the front conductive boat pin and the bottom of the rear conductive boat pin respectively have a first support surface and a second support surface for contacting a support assembly in the process chamber.

5. The wafer boat assembly according to claim 4, wherein the support assembly comprises two support rods extending along the axis of the process chamber and spaced apart in a horizontal direction perpendicular to the axis of the process chamber; the front conductive boat pins are arranged in pairs on the corresponding wafer boat, and the rear conductive boat pins are arranged in pairs on the corresponding wafer boat, with the two first support surfaces of each pair of the front conductive boat pins being configured to contact the two support rods in a one-to-one correspondence, and the second support surfaces of each pair of the rear conductive boat pins being configured to contact the two support rods in a one-to-one correspondence.

6. The wafer boat assembly according to claim 5, wherein the bottom of the front conductive boat pins further comprises a front stopper protruding downwardly relative to the first support surface, and the two front stoppers on the bottom of each pair of the front conductive boat pins are located between the two first support surfaces, so that when the corresponding wafer boat is placed on the support rod, the two front stoppers limit the position of the wafer boat in a direction perpendicular to the axis of the process chamber; and/or,
the bottom of the rear conductive boat pins further comprises a rear stopper protruding downwardly relative to the second support surface, and the two rear stoppers on the bottom of each pair of the rear conductive boat pins are located between the two second support surfaces, so that when the corresponding wafer boat is placed on the support rod, the two rear stoppers limit the position of the wafer boat in a direction perpendicular to the axis of the process chamber.

7. The wafer boat assembly according to claim 1 or 2, **characterized in that** each wafer boat comprises a plurality of mounting tabs and a plurality of groups of spacers, the plurality of mounting tabs are vertically arranged and extend along the axis of the process chamber and are spaced apart in a direction perpendicular to the axis of the process chamber, the spacers are arranged between adjacent mounting tabs to maintain spacing between adjacent mounting tabs and to electrically connect adjacent mounting tabs, the projection positions of the plurality of spacers in each group on the mounting tabs correspond;
the front conductive boat pin further comprises at least one front boat pin connector, which is arranged between adjacent mounting tabs and fixedly connected to the corresponding mounting tab, the projection position of the front boat pin connector on the mounting tab corresponds to the projection position of the corresponding group of spacers of the wafer boat on the mounting tab; and/or
the rear conductive boat pin further comprises at least one rear boat pin connector, which is arranged between adjacent mounting tabs and fixedly connected to the corresponding mounting tab, the projection position of the rear boat pin connector on the mounting tab corresponds to the projection position of the corresponding group of spacer blocks of the wafer boat on the mounting tab.

8. The wafer boat assembly according to claim 7, **characterized in that** each wafer boat further comprises a plurality of fastening components, the mounting tab is formed with a plurality of first mounting holes extending through the mounting tab in a thickness direction, and the spacer is formed with a first avoidance hole, the positions of the plurality of spacers correspond to the positions of the plurality of first mounting holes, the plurality of fastening components pass through the first mounting holes of the plurality of mounting tabs and the first avoidance hole of each spacer to securely connect the plurality of mounting tabs;
the front boat pin connector is formed with at least one second mounting hole corresponding to the position of the first mounting hole, the fastening component passing through the second mounting hole and the corresponding plurality of first mounting holes securely connects the front boat pin connector to the corresponding mounting tab;
the rear boat pin connector is formed with at least one third mounting hole corresponding to the position of the first mounting hole, the fastening component passing through the third mounting hole and the corresponding plurality of first mounting holes securely connects the rear boat pin connector to the corresponding mounting tab.

9. A semiconductor process equipment, **characterized in** comprising a power supply component, a process chamber, and the wafer boat assembly according to any one of claims 1 to 8.

10. The semiconductor process equipment according to claim 9, wherein the process chamber is provided with two support rods extending along the axis of the process chamber and spaced apart in a horizontal direction perpendicular to the axis of the process chamber, for supporting the plurality of wafer boats;
at least one pair of locking assemblies is also fixedly disposed in the process chamber, each pair of locking components corresponding to ends of two support rods on the same side, for locking a rotation angle of the support rods.

11. The semiconductor process equipment according to claim 10, wherein the locking component comprises a bracket and a pressing plate, the bracket being fixedly mounted in the process chamber; the bracket having a fixing groove in which the end of the support rod is mounted; and ends of the pressing plate being fastened to the bracket on either side of the fixing groove, respectively, so that the rotation angle of the support rod is locked through friction between the pressure plate and the support rod.

12. The semiconductor process equipment according to claim 10, wherein the support rod comprises a support stick and at least one first insulating support sleeve and two second insulating support sleeves sleeved on the support stick, the first insulating support sleeve being used to support the front conductive boat pin and the rear conductive boat pin of adjacent wafer boats on opposite sides of each other, and the second insulating support sleeve being used to support the boat pin of the wafer boat adjacent to the opening on one side of the process chamber.

13. The semiconductor process equipment according to claim 12, **characterized in that** the support rod further comprises a plurality of fixing sleeves, each of which is mounted on the support rod, and a fixing sleeve is provided at each end of each first insulating support sleeve and each second insulating support sleeve, the fixing sleeve being used to lock a position of the corresponding first insulating support sleeve or second insulating support sleeve along an extension direction of the support rod.

14. The semiconductor process equipment according to claim 13, **characterized in that** the support rod further comprises at least one fixing plate, each of which corresponds to a first insulating support sleeve and is fixedly connected between the two fixing sleeves at each end of the corresponding first insulating support sleeve.
